(19) Europäisches Patentamt
European Patent Office
Office européen des brevets

(11) **EP 1 981 167 B1**

(12) **EUROPEAN PATENT SPECIFICATION**

(45) Date of publication and mention
of the grant of the patent:
**06.07.2011 Bulletin 2011/27**

(51) Int Cl.:
*H04B 10/00* (2006.01)   *H05B 33/08* (2006.01)

(21) Application number: **08007178.0**

(22) Date of filing: **11.04.2008**

(54) **Method and device for converting an input voltage into a galvanically separated output signal**

Verfahren und Vorrichtung zur Umwandlung einer Eingangsspannung in ein galvanisch getrenntes Ausgangssignal

Procédé et dispositif de conversion d'une tension d'entrée dans un signal de sortie séparé de manière galvanique

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **13.04.2007 NL 1033688**

(43) Date of publication of application:
**15.10.2008 Bulletin 2008/42**

(73) Proprietor: **Omron Europe B.V.**
**2132 JD Hoofddorp (NL)**

(72) Inventor: **Bastiaens, Petrus Henricus**
**5211 XW Den Bosch (NL)**

(74) Representative: **Valkonet, Rutger et al**
**Algemeen Octrooi- en Merkenbureau**
**P.O. Box 645**
**5600 AP Eindhoven (NL)**

(56) References cited:
**US-A- 4 197 471      US-A- 4 771 219**
**US-A1- 2005 139 791**

## Description

The invention relates to a method, a device, an input module, and an industrial control system for converting an input voltage into a galvanically separated output signal.

It is usual in an industrial automation system, for example provided with one or several programmable logic control units (PLCs), to apply digital output signals of sensors to an input circuit so as to be read, wherein the output of a sensor behaves as a contact switched by a sensor, one side of the contact being connected to a supply voltage and the other side being connected to the input of the input circuit, thus forming an input signal for the input circuit. When the output of the sensor is activated, the input of the input circuit is connected to the supply voltage. An "ON" condition is thus established. The voltage returns to zero when the contact is opened. A leakage current may continue to flow in some cases, with the result that the input voltage does not fully return to zero. An "OFF" condition is established when the input voltage lies below a certain value. The input circuit thus forms a switched load according to international standards such as, for example, IEC 61131-2, having certain input currents and voltages. The supply voltage for reading out digital signals from sensors in industrial systems is usually 24 V.

A galvanically separated application of the read signal to the control system achieves that any malfunctions and voltage peaks in the sensor circuits cannot enter the control system. A known solution in this respect is a circuit with an optocoupler, wherein the input signal controls a light-emitting diode (LED) whose emitted light is incident on the optically sensitive base of a phototransistor, said LED and said phototransistor being spatially separated from one another, and wherein the phototransistor enters the conductive state when the light reaches the base thereof.

The connections of the phototransistor thus constructed are available for further input into the control system. In such a system, the current through the LED is determined by a series resistor which limits the current through the LED. A parallel resistor may be connected parallel to the LED, so that the overall arrangement forms a more or less ohmic load. The parallel resistor ensures that any leakage current does not lead to an "ON" condition. This method of coupling of sensor output signals to industrial control systems has been in use for many years. An example of a such a circuit, adapted for AC input voltage, can be found in United States patent number US4,197,471, figure 2.

Furthermore United States patent application US2005/0139791A1 discloses an interface circuit between an input circuit and an industrial automation system including an optocoupler. The interface circuit allows a first current loading the input circuit to increase linearly with the input voltage up to a threshold voltage. When the input voltage transgresses the threshold voltage the first current through the load is limited, while at the same time a second current is supplied to the optocoupler, which second current is also limited. The overall UI curve thus shows linear behaviour up to the threshold voltage and a sharp increase or slope for voltages beyond the threshold voltage.

In industrial control systems a plurality of such input circuits is often combined into a single module . A problem here is, however, that the dissipation is so high, especially in the series resistor, that the number of input circuits that can be combined in this manner is limited.

Active current-limiting input circuits have appeared on the market for the purpose of solving the problem of heat dissipation, in which circuits an ON condition is defined when an input voltage is higher than a given voltage, for example 10 V, and an OFF condition is detected when an input current drops below a given value, for example 1.5 mA. The input current is limited to a fixed value of, for example, 3 mA in the ON state irrespective of the input voltage.

Such input circuits comprise control circuits which require a supply voltage. The voltage present for supplying the switching contact is used for this. This renders it difficult to combine a number of input circuits into a single module because often only one supply voltage is available, in which case the input circuits are electrically directly coupled via the supply.

Although such input circuits comply with the standards, they still exhibit a strongly non-linear behaviour as regards the relationship between input current and input voltage. It is desirable for certain critical applications that the input should behave as a resistor, i.e. with the input current following the input voltage, whereby at the same time the heat dissipation is limited.

Accordingly it is an object of the present invention to provide an input circuit which generates a current that is substantially proportional to the input voltage and in which the heat dissipation is reduced.

According to a first aspect of the invention, this object is achieved by a method of converting an input voltage into a galvanically separated output signal according to appended claim 1.

In this manner the input current is governed by a load that behaves in an Ohmic manner for voltages up to the current limitation. All available input current can be guided to the galvanically separated coupling in the case of current limitation, so that the heat dissipation is limited to the product of input voltage and limited current.

A portion of the available current may be required for detecting the input voltage, loading the input, and supplying the galvanically separated coupling with current.

In an embodiment the input current may be even further reduced as the input voltage rises, i.e. when the rising input voltage transgresses the threshold, because the increase in current to the galvanically separated coupling can be less than the decrease in current through the load.

In an embodiment the input current can still remain constant at a rising input voltage, when the rising input voltage passes the threshold value, because the increase in the current to the galvanically separated coupling is equal to the decrease in the current through the load.

An embodiment also comprises the step of supplying the galvanically separated coupling with a current that is proportional to the difference between the input voltage and the predetermined threshold value when the input voltage lies above the predetermined threshold value and the current lies below the limitation value, wherein, as long as the current supplied to the galvanically separated coupling is not limited, the increase in the current along with the input voltage is greater than the decrease in the current along with the input voltage in the step of loading the input with a current that is proportional to the difference between the predetermined threshold value and the input voltage when the input voltage is higher than the predetermined threshold value.

The advantage of this embodiment is that the input current increases proportionally with the input voltage also after the predetermined threshold value has been reached. The input current increases continuously with the input voltage.

A further embodiment is such that in the step of loading the input with a current that is proportional to the difference between the predetermined threshold value and the input voltage when the input voltage is higher than the predetermined threshold value, the increase in the current to the galvanically separated coupling is equal to the decrease in the current to the load augmented by a same increase as in the step of loading the input with a current that is proportional to the input voltage when the input voltage is lower than a predetermined threshold value, has the advantage that the apparent resistance experienced at the input terminals is the same for an input voltage lower than and higher than the predetermined threshold value. It accordingly appears to a sensor connected to the input terminals as if it is loaded by one and the same resistance over the entire input voltage range until the current limitation becomes active.

According to a second aspect of the invention, the object is achieved by a device according to appended claim 4.

According to the second aspect of the invention, the device is supplied from the input voltage. Thus no separate supply voltage is necessary for operating the device according to the second aspect of the invention. This has the advantage that a plurality of devices according to the invention can be joined together, galvanically separated, in a single module.

BRIEF DESCRIPTION OF THE FIGURES

Figure 1 shows a device according to the prior art.

Figure 2 shows a UI-curve according to the prior art and belonging to the device of figure 1.
Figure 3 shows a device according to the prior art.
Figure 4 shows a UI-curve according to the prior art and belonging to the device of figure 3.
Figure 5 is a block diagram of a device according to the invention.
Figure 6 shows a UI-curve according to the invention and belonging to the device of figure 5.
Figure 7 is a schematic circuit of a device according to an exemplary embodiment of the invention.

DETAILED DESCRIPTION OF THE FIGURES

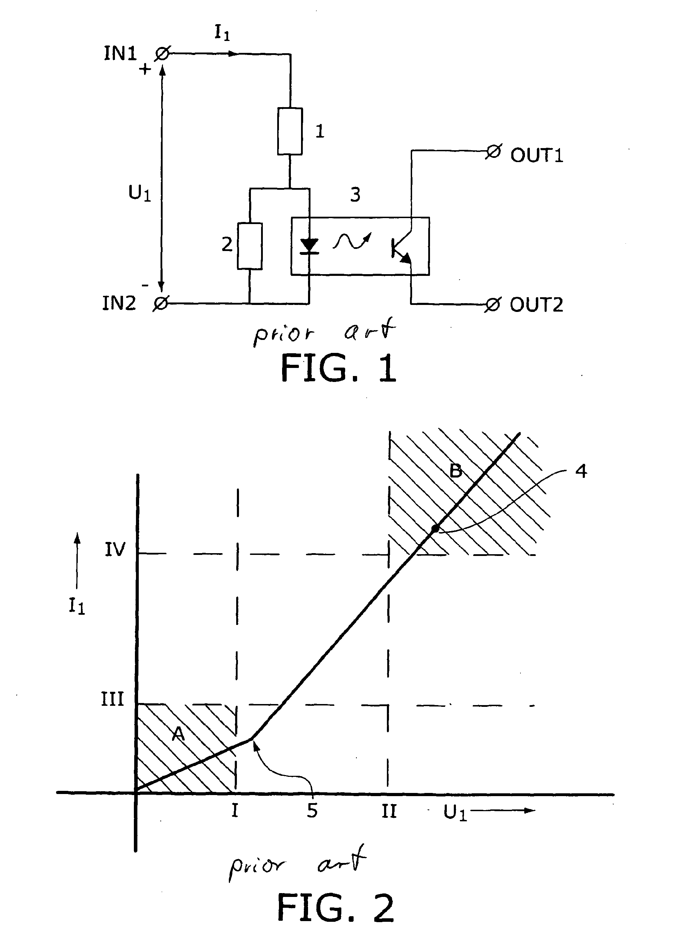

Figure 1 shows a device according to the prior art. When an input voltage U1 is applied to the input terminals IN1 and IN2, a current I1 will start to flow through a resistor 1, whereupon the current I1 will divide into a current through the light-emitting diode (LED) of an optocoupler 3 and the resistor 2, provided the current is strong enough. If the current through the LED of the optocoupler 3 is strong enough, and the latter gives sufficient light, the phototransistor of the optocoupler 3 will become conductive, so that a current path is created across the output terminals OUT1 and OUT2. It will be clear that the circuit of figure 1 behaves as a resistor across the input terminals IN1 and IN2 over the entire range of the input voltage U1.

Figure 2 shows the behaviour of the circuit of figure 1 in a so-termed UI diagram, in which the input voltage U1 is plotted on the horizontal axis and the input current I1 on the vertical axis. For low values of the voltage U1 the current I1 will flow through the resistors 1 and 2 in accordance with a curve 4 that starts at the origin and continues up to the bend 5 in curve 4, which indicates the point where the LED of the optocoupler 3 enters the conductive state. As the input voltage U1 rises further, the input current will increase linearly with the input voltage from that point onwards.

The region A in figure 2 represents the region where the optocoupler is definitely in an OFF state, i.e. there is no conduction between the terminals OUT1 and OUT2. This region is bounded by broken lines 1 and 3 and the axes of the graph of figure 2. In this region A, both the current and the voltage are so low that the LED of the optocoupler 3 either is not conducting at all or gives so little light that the phototransistor of the optocoupler 3 is not in the conductive state.

The region B in figure 2 represents the region where the optocoupler is definitely in a conductive state, i.e. the LED of the optocoupler 3 gives so much light that the phototransistor of the optocoupler 3 has become conductive and a conductive path has arisen between the terminals OUT1 and OUT2. In the transition zones along the curve 4 between the regions A and B, however, it may be uncertain at which point the LED of the optocoupler enters the conductive state or when the phototransistor of the optocoupler 3 becomes conductive.

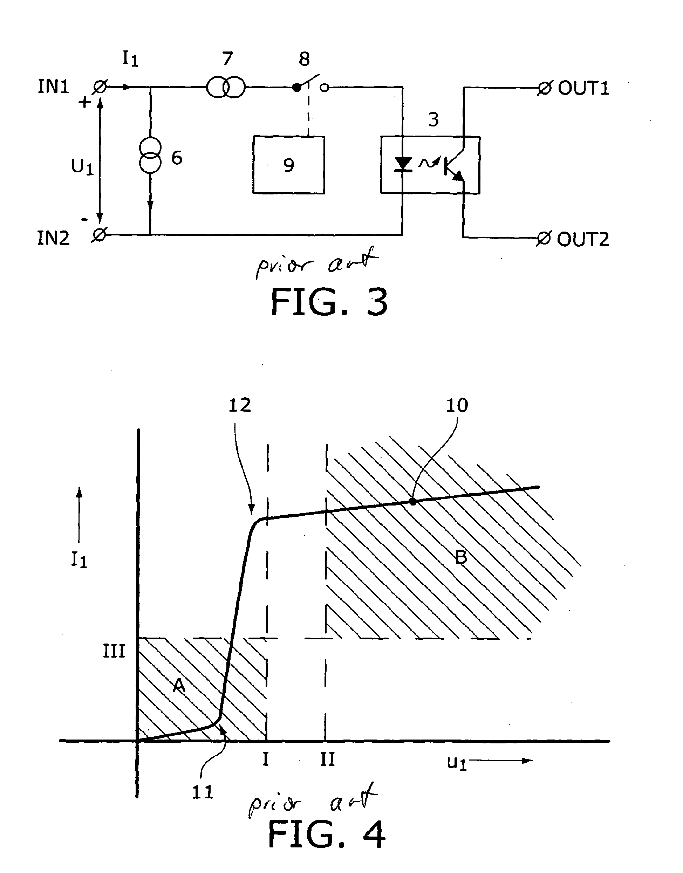

Figure 3 shows a device according to the prior art in which a current source 6 is arranged across the input terminals IN1 and IN2, thus forming a load with a constant current when the device is in the OFF state. The use of a current source renders it possible to reduce the dissipation of the load, because the dissipation is equal to the product of the input voltage U1 and the current through the current source 6, which implies that the dissipation will rise only linearly with a rising input voltage instead of with square of terminated the input voltage U1 as would be the case if the input terminals IN1 and IN2 were closed off with a resistor.

Furthermore, the circuit of figure 3 comprises a limited current source 7 which is switched on by means of a control circuit 9 and a switch 8 when the input voltage U1 rises to above a certain value. The current delivered by the current source 7 will flow through the LED of the optocoupler 3, which current through the current source 7 is strong enough to cause the LED of the optocoupler to generate sufficient light for the phototransistor of the optocoupler 3 to become conductive, so that a current path is created between the output terminals OUT1 and OUT2. The control circuit 9 is arranged such that said switch 8 is opened again when the input voltage has dropped to a point where the input current is lower than a given value, so that the LED of the optocoupler 3 does not receive any more current.

Figure 4 shows a UI-curve 10 belonging to the circuit of figure 3. Starting from the origin of figure 4, it is apparent that the current I1 increases only little with a rise in the input voltage U1, but that at a bend I1 the input current starts to increase quickly as a result of the detection of a sufficient input voltage by the control circuit 9. At a bend 12, the current source 7 becomes limited and ensures that a further increase in the input voltage U1 hardly causes the input current to rise at all, so that the dissipation is proportional to the input voltage only and not to the square thereof.

Region A in figure 4 indicates that the device is in the OFF state when the input voltage is lower than I and the input current is lower than III. The device of figure 3 is in the ON state, represented by region B in figure 4, when the input voltage is higher than II and the input current is higher than III. It is obvious that the UI-curve of figure 4 has a strongly non-linear character.

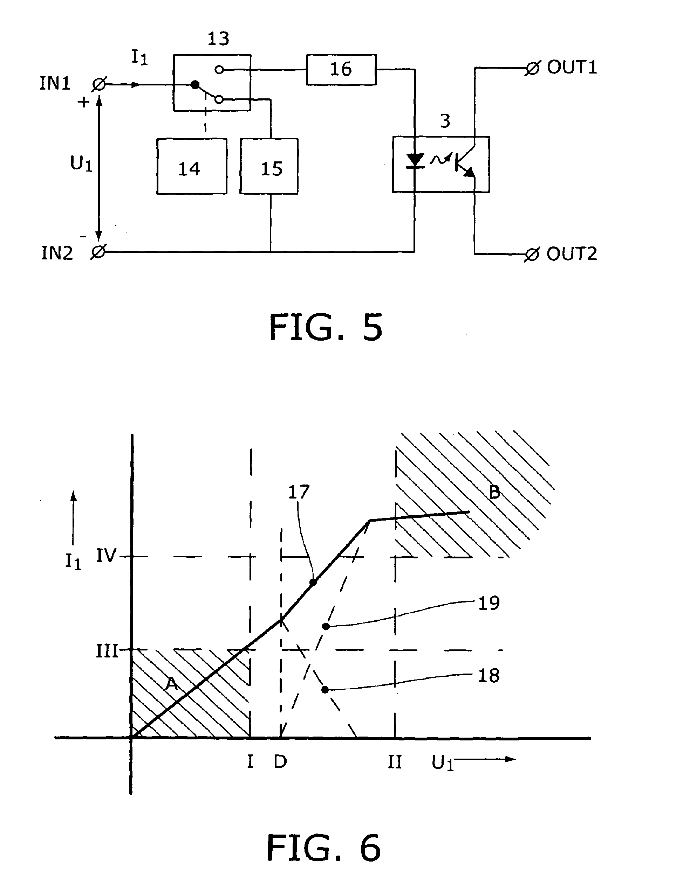

Figure 5 shows a device according to the invention, wherein a current control circuit 13 distributes an input current I1 over a load 15 and a limited current source 16.

The current control circuit 13 is driven by a voltage detection circuit 14 such that the input current is guided mainly through the load 15 when the input voltage U1 at the terminals IN1 and IN2 is lower than a preset threshold value D, and the input current I1 is determined by the limited current source 16 when the voltage U1 is higher than the preset threshold value D.

It is typical of the control circuit 13 that the switch-over from the load 15 to the limited current source 16 takes place gradually, the current through the load 15 being gradually scaled down upon an increase in the input voltage U1 and the current being gradually stepped up by the limited current source 16 up to a maximum value. As is furthermore apparent from figure 5, the current is passed by the limited current source 16 through the LED of the optocoupler 3, which illuminates the phototransistor of the optocoupler 3 so that the latter becomes conductive, which creates a current path with the output terminals OUT1 and OUT2. When the voltage U1 across the input terminals IN1 and IN2 becomes lower, the current through the limited current source 16 will decrease gradually and the current through the load 15 will increase gradually until the input current flows mainly through the load 15.

The behaviour of the device according to the block diagram of figure 5 is depicted in the UI-curve of figure 6.

It can be seen in figure 6 that the UI-curve rises more or less linearly with the input voltage for input voltages U1 lower than the threshold value D. The control circuit 13 in this phase ensures that all current I1 is guided through the load 15. As the voltage U1 rises from the threshold value D, the control circuit causes the current through the load 15 to decrease, as is shown by a broken line 18 in figure 6. At the same time, at input voltages U1 higher than the threshold value D, it is ensured that the current through the limited current source 16 increases as indicated by a broken line 19, with the result that the overall current I1 has a continuous gradient from the point where the curve 17 intersects the broken line D. The current source 16 enters the limitation state at the point where the broken line 19 intersects the curve 17. From that point onwards, the current I1 will not or substantially not increase any more with higher voltages U1, so that the dissipation is proportional to the input voltage only and not to the square thereof.

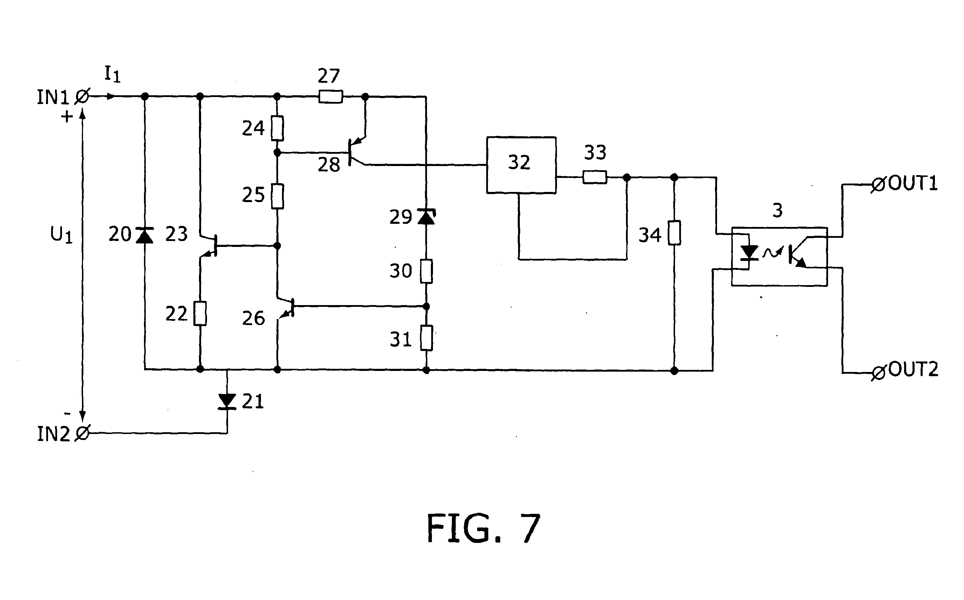

Figure 7 shows an embodiment corresponding to the block diagram of figure 5 by way of example.

The voltage detection circuit 14 of figure 5 is formed by a transistor 26, resistors 30 and 31 and Zener diode 29. The control circuit 13 is formed by transistors 23 and 28 and resistors 24, 25, 27. The load 15 of figure 5 is formed by a resistor 22.

The limited current source 16 is formed by a voltage regulator 32 and a resistor 33, the non-controlled voltage input of the voltage regulator 32 being connected to the collector of transistor 28, the output to resistor 33, and the control input to the downstream side of resistor 33 and also to the positive input of the optocoupler 3. This is a well-known application of a voltage regulator such as, for example, the voltage regulator with type number LM317L. A practical current to which the current limitation control 32 in conjunction with the resistor 33 limits the current to the optocoupler 3 is 3 mA.

The transistor 23 is in the saturated state at low voltages owing to the resistors 24 and 25 which drive the base of the transistor 23. As a result of this, the input voltage U1 at the input terminals IN1 and IN2 is loaded by resistor 22. The transistors 28 and 26 are not conducting at the low input voltage U1.

As the input voltage U1 rises to above the Zener voltage of Zener diode 29, a voltage drop appears across the resistors 30 and 31, which together form a voltage divider. When the voltage U1 is high enough, the transistor 26 will start to conduct. U1 has reached the threshold value D at this moment, which causes the voltage at the base of transistor 23 to decrease, thus decreasing the current through the load 22, while at the same time the voltage drop across the resistor 24 increases, which causes the transistor 28 to enter into the conductive state and to supply a current to the current limiter 32, 33. This current delivered by the transistor 28 flows through the LED of the optocoupler 3 and through resistor 34, which is connected in parallel to the LED of the optocoupler 3. The resistor 34 provides a zero potential at the input of the LED of the optocoupler 3 as long as this LED is not yet in the conductive state.

When the input voltage U1 at the input terminals IN1 and IN2 decreases, the voltage in the centre of the voltage divider comprising the resistors 30 and 31 will drop, so that the control of the base of the transistor 26 will weaken and subsequently the voltage at the base of transistor 23 will drop, the transistor 23 thus becoming conductive. At the same time the voltage across the resistor 24 will decrease, so that the transistor 28 will gradually become non-conductive. At a certain moment the current from the collector of 28 will be so weak that the LED of the optocoupler 3 will give insufficient light for causing the phototransistor of the optocoupler 3 to conduct. If U1 is so low that the voltage at the base of the transistor 26 becomes too low for causing the transistor 26 to conduct, i.e. the input voltage U1 is lower than the threshold value D, the input current I1 will be entirely determined by the resistor 22. Once the input voltage has dropped sufficiently, i.e. to below level I, and the input current accordingly to below level III, the device has reached the OFF state.

The threshold value D of figure 7 is determined by Zener diode 29, resistors 30 and 31, and the base-emitter voltage of transistor 26 in accordance with the following formula :

$$ D \approx U29 + Vbe(26) \cdot \frac{R30 + R31}{R30}, $$

where U29 is the Zener voltage across the Zener diode 29, R30 the resistance of resistor 30, R31 the resistance of resistor 31, and Vbe(26) the base-emitter voltage of transistor 26 (normally around 0.7 V). The ratio of the resistors 30 and 31 lies in a range of approximately 1 to 10. The resistor value 30 is chosen to be as high as possible , a practical value being 56 kΩ, so as to reduce the current (losses) through the Zener diode 29 and the base of the transistor 26 as much as possible. The Zener voltage U29 is approximately 5.6 V. The threshold value D accordingly lies in a range of approximately 7 V to approximately 14 V.

The resistor 27 together with the ratio of the resistors 30 and 31 determines the angle of the current to the galvanically separated coupling as long as this current is not limited. Given the above ratio of the resistors 30 and 31, practical values for the resistor 31 lie in a range of approximately 300 to 600 Ω.

The resistor 24 governs the continuity between the start of the decrease to the current through the load 22, when the input voltage becomes U1 > D, and the start of the supply to the galvanically separated coupling, i.e. the optocoupler 3, viz. curve 19 in figure 6. If the resistance value of resistor 24 is chosen to be too high, the transistor 28 may conduct already in the OFF state, region A in the UI-curve of figure 6. If the resistance value of 24 is chosen to be too low, the transistor 28 will be non-conductive also in the ON state, region B in figure 6. The resistance value of resistor 24 must lie below approximately 16 kΩ. A practical value for the resistor 24 is 10 kΩ.

The resistance value of 25 is chosen to be as high as possible so as to keep the base current for the transistor 28 low and to reduce power losses as much as possible. A practical value is 47 kΩ.

The amplification Hfe for the transistor 23 is chosen to be as high as possible. A preferred value is 250, but 75 is a practical lower limit.

The resistor 22 may be chosen such that the current I1 is 1 mA for an input voltage U1 of 5 V. A practical value of 3.5 kΩ is obtained owing to the voltage drop across the transistor 23 and the diode 21.

It will be apparent to those skilled in the art that the embodiments described herein are mere examples only, and that these examples may be deviated from without departing from the scope of protection of the claims that follow hereinafter.

**Claims**

1. Method of converting an input voltage (U_1) into a galvanically separated output signal, comprising the steps of:

    - detecting the input voltage (U_1) at an input (IN1, IN2);
    - loading the input (IN1, IN2) with a first current through a galvanically separated coupling (3) with current limitation (16; 32, 33) such that the first current lies below a current limitation value;
    - applying a load (15, 22) to the input (IN1, IN2) by loading the input (IN1, IN2) with a second current that is proportional to the input voltage (U_1) when the input voltage (U_1) is lower than a predetermined threshold value (D),

- generating an output signal (OUT1, OUT2) by means of said galvanically separated coupling (3);

**characterised in that** the step of applying a load (15, 22) to the input (IN1, IN2) further comprises:

- loading the input (IN1, IN2) with a third current that is anti proportional (18) to the absolute difference between the predetermined threshold value (D) and the input voltage ($U_1$) when the input voltage ($U_1$) is higher than the predetermined threshold value (D), and

wherein the first current is proportional to the difference between the input voltage ($U_1$) and the predetermined threshold value (D) as long as the input voltage ($U_1$) is higher than the predetermined threshold value (D).

2. Method according to claim 1, wherein the slope (19) in the first current is greater than the absolute value of the negative slope (18) in the third current.

3. Method according to claim 2, wherein in the curve of the input current ($I_1$) versus input voltage ($U_1$) the slope in the first current is substantially equal to sum of the absolute value of negative slope in the third current and the slope of the second current, such that the slope of the input current ($I_1$) versus the input voltage ($U_1$) has a continuous gradient.

4. Device for converting an input voltage ($U_1$) into a galvanically separated output signal (OUT1, OUT2), comprising

- an input (IN1, IN2) for connecting to the input voltage ($U_1$);
- a voltage detection circuit (14; 26, 29, 30, 31) for detecting that a predetermined threshold value (D) of the input voltage ($U_1$) is reached;
- a galvanically separated coupling (3) for generating an output signal (OUT1, OUT2);
- a current limitation circuit (16, 32, 33) for supplying a first current to the galvanically separated coupling (3), the current limitation circuit (16, 32, 33) and the galvanically separated coupling (3) being in series connected with the input (IN1, IN2);
- a load (15, 22) connected to the input (IN1, IN2);
- a control circuit (13, 23-25, 27, 28) for controlling current limitation circuit (16, 32, 33) and the load (15, 22);

wherein said device is adapted to perform the steps of the method according to any one of the claims 1 to 3.

5. Device according to claim 4, wherein the galvanically separated coupling (3) is an optocoupler.

6. Device according to claim 5, wherein the device is supplied from the input voltage ($U_1$).

**Patentansprüche**

1. Verfahren zur Umwandlung einer Eingangsspannung ($U_1$) in ein galvanisch getrenntes Ausgangssignal, mit den folgenden Schritten:

- die Eingangsspannung ($U_1$) wird an einem Eingang (IN1, IN2) erfasst,
- der Eingang (IN1, IN2) wird über eine galvanisch getrennte Kopplung (3) mit Strombegrenzung (16; 32, 33) so mit einem ersten Strom belastet, dass der erste Strom unterhalb eines Strombegrenzungswertes liegt,
- an den Eingang (IN1, IN2) wird eine Last (15, 22) angelegt, indem der Eingang (IN1, IN2) mit einem zweiten Strom belastet wird, der proportional zur Eingangsspannung ($U_1$) ist, wenn die Eingangsspannung ($U_1$) niedriger als ein vorbestimmter Schwellenwert (D) ist,
- mittels der galvanisch getrennten Kopplung (3) wird ein Ausgangssignal (OUT1, OUT2) erzeugt,

**dadurch gekennzeichnet, dass** der Schritt, bei dem an den Eingang (IN1, IN2) eine Last (15, 22) angelegt wird, ferner Folgendes umfasst:

- der Eingang (IN1, IN2) wird mit einem dritten Strom belastet, der umgekehrt proportional (18) zur absoluten Differenz zwischen dem vorbestimmten Schwellenwert (D) und der Eingangsspannung ($U_1$) ist, wenn die Eingangsspannung ($U_1$) höher als der vorbestimmte Schwellenwert (D) ist, und

wobei der erste Strom proportional zur Differenz zwischen der Eingangsspannung ($U_1$) und dem vorbestimmten Schwellenwert (D) ist, solange die Eingangsspannung ($U_1$) höher als der vorbestimmte Schwellenwert (D) ist.

2. Verfahren nach Anspruch 1, bei dem die Steilheit (19) im ersten Strom größer als der Absolutwert der negativen Steilheit (18) im dritten Strom ist.

3. Verfahren nach Anspruch 2, bei dem bei der Kurve des Eingangsstroms ($I_1$) über die Eingangsspannung ($U_1$) die Steilheit im ersten Strom im wesentlichen gleich der Summe des Absolutwertes der negativen Steilheit im dritten Strom und der Steilheit des zweiten Stromes ist, derart, dass die Steilheit

des Eingangsstroms (I$_1$) über die Eingangsspannung (U$_1$) einen kontinuierlichen Gradienten hat.

**4.** Vorrichtung zur Umwandlung einer Eingangsspannung (U$_1$) in ein galvanisch getrenntes Ausgangssignal (OUT1, OUT2), mit

- einem Eingang (IN1, IN2) zur Verbindung mit der Eingangsspannung (U$_1$),
- einer Spannungserfassungsschaltung (14; 26, 29, 30, 31), die erfasst, dass ein vorbestimmter Schwellenwert (D) der Eingangsspannung (U$_1$) erreicht ist,
- einer galvanisch getrennten Kopplung (3), die ein Ausgangssignal (OUT1, OUT2) erzeugt,
- einer Strombegrenzungsschaltung (16, 32, 33), die die galvanisch getrennte Kopplung (3) mit einem ersten Strom versorgt, wobei die Strombegrenzungsschaltung (16, 32, 33) und die galvanisch getrennte Kopplung (3) mit dem Eingang (IN1, IN2) in Reihe geschaltet sind,
- einer mit dem Eingang (IN1, IN2) verbundenen Last (15, 22),
- einer Steuerschaltung (13, 23-25, 27, 28) zur Steuerung der Strombegrenzungsschaltung (16, 32, 33) und der Last (15, 22),

wobei die Vorrichtung so ausgebildet ist, dass sie die Schritte des Verfahrens nach einem der Ansprüche 1 bis 3 ausführt.

**5.** Vorrichtung nach Anspruch 4, bei der die galvanisch getrennte Kopplung (3) ein Optokoppler ist.

**6.** Vorrichtung nach Anspruch 5, bei der die Vorrichtung von der Eingangsspannung (U$_1$) versorgt wird.

**Revendications**

**1.** Procédé de conversion d'une tension d'entrée (U$_1$) en un signal de sortie séparé galvaniquement, comprenant les étapes consistant à :

- détecter la tension d'entrée (U$_1$) à une entrée (IN1, IN2) ;
- charger l'entrée (IN1, IN2) avec un premier courant par l'intermédiaire d'un couplage à séparation galvanique (3) avec une limitation de courant (16; 32, 33) de sorte que le premier courant soit inférieur à une valeur de limitation de courant ;
- appliquer une charge (15, 22) à l'entrée (IN1, IN2) en chargeant l'entrée (IN1, IN2) avec un deuxième courant qui est proportionnel à la tension d'entrée (U$_1$) lorsque la tension d'entrée (U$_1$) est inférieure à une valeur de seuil prédéterminée (D) ;

- générer un signal de sortie (OUT1, OUT2) au moyen dudit couplage à séparation galvanique (3) ;

**caractérisé en ce que** l'étape d'application d'une charge (15, 22) à l'entrée (IN1, IN2) consiste en outre à :

- charger l'entrée (IN1, IN2) avec un troisième courant qui est anti-proportionnel (18) à la différence absolue entre la valeur de seuil prédéterminée (D) et la tension d'entrée (U$_1$) lorsque la tension d'entrée (U$_1$) est supérieure à la valeur de seuil prédéterminée (D), et

dans lequel le premier courant est proportionnel à la différence entre la tension d'entrée (U$_1$) et la valeur de seuil prédéterminée (D) tant que la tension d'entrée (U$_1$) est supérieure à la valeur de seuil prédéterminée (D).

**2.** Procédé selon la revendication 1, dans lequel la pente (19) du premier courant est supérieure à la valeur absolue de la pente négative (18) du troisième courant.

**3.** Procédé selon la revendication 2, dans lequel, sur la courbe du courant d'entrée (I$_1$) en fonction de la tension d'entrée (U$_1$), la pente du premier courant est sensiblement égale à la somme de la valeur absolue de la pente négative du troisième courant et de la pente du deuxième courant, de sorte que la pente du courant d'entrée (I$_1$) en fonction de la tension d'entrée (U$_1$) a un gradient continu.

**4.** Dispositif pour convertir une tension d'entrée (U$_1$) en un signal de sortie séparé galvaniquement (OUT1, OUT2), comprenant :

- une entrée (IN1, IN2) pour une connexion à la tension d'entrée (U$_1$) ;
- un circuit de détection de tension (14 ; 26, 29, 30, 31) pour détecter qu'une valeur de seuil prédéterminée (D) de la tension d'entrée (U$_1$) est atteinte ;
- un couplage à séparation galvanique (3) pour générer un signal de sortie (OUT1, OUT2) ;
- un circuit de limitation de courant (16, 32, 33) pour délivrer un premier courant au couplage à séparation galvanique (3), le circuit de limitation de courant (16, 32, 33) et le couplage à séparation galvanique (3) étant connectés en série avec l'entrée (IN1, IN2) ;
- une charge (15, 22) connectée à l'entrée (IN1, IN2) ;
- un circuit de commande (13, 23 à 25, 27, 28) pour commander le circuit de limitation de courant (16, 32, 33) et la charge (15, 22) ;

dans lequel ledit dispositif est conçu pour effectuer les étapes du procédé selon l'une quelconque des revendications 1 à 3.

**5.** Dispositif selon la revendication 4, dans lequel le couplage à séparation galvanique (3) est un optocoupleur.

**6.** Dispositif selon la revendication 5, dans lequel le dispositif reçoit la tension d'entrée ($U_1$).

prior art

# FIG. 1

prior art

# FIG. 2

prior art

# FIG. 3

prior art

# FIG. 4

# FIG. 5

# FIG. 6

FIG. 7

EP 1 981 167 B1

**EP 1 981 167 B1**

**REFERENCES CITED IN THE DESCRIPTION**

**Patent documents cited in the description**

- US 4197471 A

- US 20050139791 A1